## Europäisches Patentamt

## European Patent Office

## Office européen des brevets

(11) Veröffentlichungsnummer: **0 044 567**
**A1**

(12) # EUROPÄISCHE PATENTANMELDUNG

(21) Anmeldenummer: 81105805.6

(22) Anmeldetag: 22.07.81

(51) Int. Cl.³: **H 01 L 21/306**
**H 01 L 21/68**

(30) Priorität: 23.07.80 DE 3027934

(43) Veröffentlichungstag der Anmeldung:
27.01.82 Patentblatt 82/4

(84) Benannte Vertragsstaaten:
DE FR GB IT

(71) Anmelder: SIEMENS AKTIENGESELLSCHAFT Berlin
und München
Postfach 22 02 61
D-8000 München 22(DE)

(72) Erfinder: Bonu, Bonu, Dipl.-Ing.
Johann-Clanze-Strasse 53
D-8000 München 70(DE)

(54) Verfahren zur einseitigen Ätzung von Halbleiterscheiben.

(57) Der Erfindung liegt die Aufgabe zugrunde, ein Verfahren zur einseitigen Ätzung von Halbleiterscheiben anzugeben, das einerseits die Unversehrtheit der zu behandelnden Halbleiterscheiben gewährleistet und andererseits den Arbeitsaufwand und den Verbrauch an Materialien reduziert.

Erfingungsgemäß wird ein Ätzverfahren so durchgeführt, daß die zu ätzende Halbleiterscheibe (6) mittels eines Drehgaskissens (7) so in einen Schwebezustand versetzt wird, daß die nicht zu ätzende Fläche der Halbleiterscheibe dem Drehgaskissen (7) zugewandt ist, während die zu ätzende Fläche der Halbleiterscheibe (6) freiliegt und daß die freiliegende Fläche der Halbleiterscheibe (6) mit Ätzmittel besprüht und wegen der Scheibenrotation geschleudert wird, daß anschließend die freiliegende Oberfläche der Halbleiterscheibe mit Sprühmittel besprüht und anschließend trockengeschleudert wird.

Anwendung bei der Herstellung von Halbleiterbauelementen und IC's.

FIG 3

SIEMENS AKTIENGESELLSCHAFT
Berlin und München

Unser Zeichen
VPA 80 P 1 1 1 3 E

0044567

**Verfahren zur einseitigen Ätzung von Halbleiterscheiben.**

Bei der Verarbeitung von Halbleitermaterialien zu gewissen Bauelementen ergibt sich oft die Notwendigkeit, daß nur eine Kreisfläche einer Halbleiterscheibe geätzt werden soll, während die gegenüberliegende Fläche der Halbleiterscheibe vom Ätzmittel ferngehalten werden muß.

Nach den üblichen Ätzmethoden muß dazu die nicht zu ätzende Halbleiteroberfläche mit einem Lack versehen werden. Dieser Lack muß durch Aufheizen getrocknet werden, danach kann das Ätzen der zweiten nicht beschichteten Halbleiterscheibe erfolgen. Dabei sind aufwendige Arbeitsvorgänge wie Spülen und Trocknen der Scheiben erforderlich, und schließlich muß der rückwärtige Lack entfernt werden, wozu ebenfalls nach Entfernen des Lacks wiederum Spül- und Trockenvorgänge erforderlich sind. Nachdem alle diese Arbeitsgänge üblicherweise so durchgeführt werden, daß mehrere Halbleiterscheiben in einer Horde angeordnet sind, ist für jeden einzelnen Arbeitsgang ein Umhorden erforderlich. Insgesamt sind zur einseitigen Ätzung von Halbleiterscheiben etwa zwanzig Prozeßschritte auszuführen, was einen hohen Arbeitsaufwand erfordert. Daneben ist auch der Aufwand von deionisiertem Wasser zum Spülen der Halbleiterscheiben sowie der Verbrauch an Chemikalien und Energie recht erheblich.

Außerdem entstehen auf der belackten Halbleiteroberfläche oftmals Schäden in Form von Verschmutzung, da gelegentlich Lackrückstände nicht restlos entfernt werden, oder aber es entstehen Kratzer oder Brüche an der behandelten Halbleiterscheibe als Folge der vielfachen Einzelarbeitsschritte, denen die Halbleiterscheibe ausgesetzt ist.

Kus 1 Lk / 16.7.1980

Aufgabe der vorliegenden Erfindung ist es daher, ein Verfahren zur einseitigen Ätzung von Halbleiterscheiben anzugeben, das einerseits die Unversehrtheit der zu behandelnden Halbleiterscheiben gewährleistet und andererseits den Arbeitsaufwand und den Verbrauch an deionisiertem Wasser, Chemikalien und Energie reduziert.

Diese Aufgabe wird erfindungsgemäß dadurch gelöst, daß die zu ätzende Halbleiterscheibe mittels eines Drehgaskissens so in einen Schwebezustand versetzt wird, daß die nicht zu ätzende Fläche der Halbleiterscheibe dem Drehgaskissen zugewandt ist, während die zu ätzende Fläche der Halbleiterscheibe freiliegt und daß die freiliegende Fläche der Halbleiterscheibe mit Ätzmittel besprüht und wegen der Scheibenrotation gleichzeitig geschleudert wird, daß anschließend die freiliegende Fläche der Halbleiterscheibe mit Spülmittel besprüht und anschließend trockengeschleudert wird.

Die erfindungsgemäße Anwendung eines Drehgaskissens verhindert einerseits eine Beschädigung oder Verschmutzung der Halbleiterscheibe und bewirkt andererseits eine Einsparung von Arbeitsgängen, d.h. einer Ersparnis von Zeit und Materialaufwand.

Es ist auch vorteilhaft, daß das Ätzmittel vor dem Besprühen aufgeheizt wird. Durch das Aufheizen des Ätzmittels vor dem Besprühen der Halbleiterscheibe kann die Ätzzeit verringert werden.

Es ist vorteilhaft, daß als Halbleitermaterial Silicium, als Ätzmittel Flußsäure und als Spülmittel deionisiertes Wasser verwendet wird. Da ausgereifte Technologien zur Herstellung und Verarbeitung von Siliciumhalbleiterbauelementen vorliegen, ist es vorteilhaft, Silicium zu verwenden.

Zum Spülen von Siliciumhalbleiterscheiben hat sich als vorteilhaft erwiesen, deionisiertes Wasser zu verwenden, da ionenhaltiges Wasser auf der Siliciumoberfläche den unkontrollierten Einbau verschiedener Ionen bewirken kann, wodurch häufig eine Verschlechterung hiernach gefertigter Halbleiterbauelemente erzielt wird.

Es ist vorteilhaft, daß das erfindungemäße Verfahren mit einer Vorrichtung ausgeführt wird, die so ausgestattet ist, daß das Drehgaskissen mittels eines Drehtellers erzeugt wird, der eine axiale Gaszuführung enthält, die von einem geeigneten Gas durchströmt wird, daß der Drehteller an seinem äußeren Umfang mehrere Anschlagbügel zur Halterung der Halbleiterscheibe aufweist, die so ausgeführt sind, daß sich bei Betrieb der Anordnung ein Drehgaskissen zwischen dem Drehteller und der Halbleiterscheibe bildet, so daß die Halbleiterscheibe an keiner Stelle den Drehteller berührt, daß eine oder mehrere Sprühvorrichtungen zum Besprühen der dem Drehgaskissen abgewandten Halbleiteroberfläche vorgesehen sind und daß eine Auffangvorrichtung für die verbrauchte Sprühflüssigkeit vorgesehen ist.

Durch diese Vorrichtung wird gewährleistet, daß die Halbleiterscheibe einerseits nicht beschädigt und andererseits hinreichend gut gehaltert wird.

Es ist auch vorteilhaft, daß an die Auffangvorrichtung eine Vorrichtung zum Erwärmen und Rückpumpen der Flüssigkeit in die Sprühvorrichtung angeschlossen ist. Durch das Rückpumpen der Flüssigkeit wird ein geringer Verbrauch an verwendeter Flüssigkeit gewährleistet; durch Erwärmen von Flüssigkeit wird eine kürzere Ätz- bzw. Reinigungsdauer der bearbeiteten Halbleiterscheibe gewährleistet.

0044567
80 P 1 1 1 3 E

Schließlich ist es vorteilhaft, daß zum Be- und Entladen des Drehtellers die Halbleiterscheiben mittels schwenkbarer Saugpinzetten befördert werden. Durch diese Maßnahme kann das Be- und Entladen der Vorrichtung mit Halbleiterscheiben automatisiert werden.

Nachfolgend wird die Erfindung anhand der Zeichnung und an einem Ausführungsbeispiel näher erläutert. Es zeigen:

Fig. 1 einen Querschnitt durch einen erfindungsgemäßen Drehteller,

Fig. 2 eine Draufsicht auf einen erfindungsgemäßen Drehteller,

Fig. 3 eine schematische Darstellung einer Anordnung zur Durchführung des erfindungsgemäßen Verfahrens zur einseitigen Ätzung von Halbleiterscheiben.

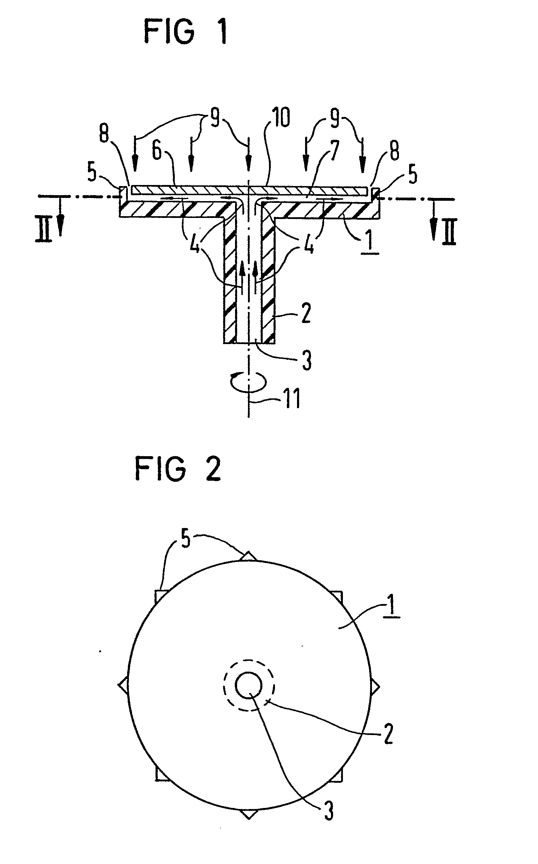

Fig. 1 zeigt einen Querschnitt durch einen erfindungsgemäßen Drehteller 1 zB aus Kunststoff, der ein Rohr 2 mit Hohlwelle aufweist, durch dessen Innenraum 3 ein zur Bildung des Gaskissens 7 geeignetes Gas hindurchgeleitet wird. Als Gas können z.B. Luft, Stickstoff oder jedes andere Gas verwendet werden, das in den niedrigen Arbeitstemperaturbereichen mit dem Scheibenmaterial chemisch nicht reagiert. Das Gas muß jedoch eine hohe chemische Reinheit aufweisen sowie frei sein von Schmutzpartikeln und Feuchtigkeit. Die Pfeile 4 deuten die Bewegungsrichtung des Füllgases an. Der Drehteller 1 weist außerdem an seinem äußeren Rand einige Anschlagbügel 5 auf, die sowohl das Weggleiten einer Halbleiterscheibe 6 von dem zwischen Drehteller 1 und Halbleiterscheibe 6 gebildeten Gaskissen 7 verhindern als auch als Mitnehmer für die Halbleiterscheibe 6 dienen, wodurch die Drehbewegung des Drehtellers 1 auf die Halbleiterscheibe 6 übertragen wird. Der verbleibende Spalt 8 zwischen dem Anschlagbügel 5 und dem äußeren Rand der Halbleiterscheibe 6 ist sehr gering und in der Größenordnung von Bruchteilen von Millimetern. Die Dimensionierung dieses Spaltes 8 hängt vom Gewicht der Halbleiterscheibe 6 einerseits und vom Druck des verwendeten Gases andererseits ab. Das in die Hohlwelle 2 eingeführte Gas durchströmt den Drehteller in Richtung der Pfeile 4. Seitlich kann es den Drehteller 1* an denjenigen Spalten zwischen Drehteller 1 und Halbleiterscheibe 6 verlassen, an denen sich kein Anschlagbügel 5 befindet. Die Halbleiterscheibe 6 wird an der dem Gaskissen 7 abgewandten Oberfläche 10 von dem Ätzmittel bzw. Spülmittel homogen besprüht, was durch die Pfeile 9 angedeutet ist. Der Drehteller 1 wird in Rotation versetzt, wobei die Symmetrieachse 11 gleichzeitig Drehachse ist.* hauptsächlich

Fig. 2 stellt eine Draufsicht auf den Drehteller nach Fig. 1 dar, der längs der Linie II-II aus Fig. 1 geschnitten ist. Am äußeren Rand des Drehtellers 1 sind die Anschlagbügel 5 angebracht. Die Bezugszeichen 3 und 2 bezeichnen die gleichen Gegenstände wie in Fig. 1.

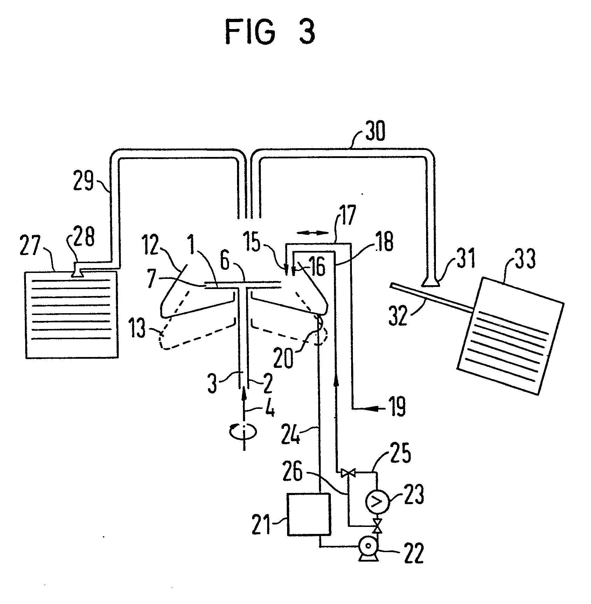

Fig. 3 ist eine schematische Darstellung einer Vorrichtung zur Durchführung des erfindungsgemäßen Verfahrens. Gleiche Gegenstände der Figuren 1, 2 und 3 wurden jeweils mit den gleichen Bezugszeichen belegt, weshalb bereits in den Figuren 1 und 2 beschriebene Gegenstände nicht nochmals beschrieben werden.

Auf einem Drehteller 1 und einem Gaskissen 7 liegt eine Halbleiterscheibe 6, die an der dem Gaskissen abgewandten Oberfläche mittels des Sprühstutzens 15 mit Spülwasser bzw. mittels des Sprühstutzens 16 mit Ätzflüssigkeit besprüht werden kann. Durch das Gaskissen 7 kann keine der beiden Flüssigkeiten auf die Unterseite der Halbleiterscheibe 6 gelangen, so daß eine einseitige Ätzung von Halbleiterscheiben mit dieser Methode und Vorrichtung gewährleistet ist. Die Sprühstutzen 15 und 16 sind so angebracht, daß sie aus der in Fig. 3 dargestellten Position heraus zur Symmetrieachse des Drehtellers 1 hin verschoben werden können, so daß jeweils einer dieser

0044567

80 P 1 1 1 3 E

Stutzen dort oberhalb der Halbleiterscheibe befestigt ist.
Unterhalb des Drehtellers 1 ist eine Auffangvorrichtung 12 angebracht, die zum Be- und Entladen des Drehtellers 1 mit
Halbleiterplatten in die strichliert gezeichnete Stellung
13 hinabgesenkt werden kann. Anstelle des Absenkens der
Auffangvorrichtung 12 in die Position 13 kann auch die Kammer
fest stehen und der Drehteller 1 relativ zur Auffangvorrichtung 12 höhenverschiebbar angebracht sein. Die Auffangvorrichtung 12 weist einen Abflußstutzen 20 auf,
durch den aufgefangene Ätzflüssigkeit über das Rohr 24
zu einem Vorratsbehälter 21 gelangen kann und von dort
über eine Umwälzpumpe 22 und einen Erwärmer 23 auf eine
gewünschte Temperatur aufgeheizt und über die Rohre 25
und 18 in den Sprühstutzen 16 zur erneuten Besprühung
von Halbleiterscheiben 6 zurückgepumpt werden kann. Ist ein
Aufheizen der Ätzflüssigkeit nicht erwünscht oder soll
die aufgeheizte Ätzflüssigkeit mit unvorgeheizter Ätzflüssigkeit gemischt werden, so kann die Ätzflüssigkeit
auch ganz oder teilweise, herkommend von der Umwälzpumpe
22 über das Rohr 26 und 18 zum Sprühstutzen 16 geleitet
werden. Zum Spülen von Halbleiterscheiben gelangt deionisiertes Wasser (angedeutet durch den Pfeil 19), in das
Zuleitungsrohr 17 und den Sprühstutzen 15. Zum automatisierten Be- und Entladen des Drehtellers 1 mit Halbleiterscheiben 6 können zwei Schwenkarme 29 und 30 verwendet werden, an deren Enden sich Saugstutzen 28 und 31
befinden. Mit dem Saugstutzen 28 kann aus einer Kassette
27 eine Halbleiterscheibe durch Ansaugen herausgehoben
werden und mittels des Schwenkarmes 29 dem Drehteller 1
zugeführt werden. Entsprechend kann der Schwenkarm 30
mittels des Saugstutzens 31 eine auf dem Drehteller 1
befindliche Halbleiterscheibe 6 ansaugen, zu einer weiteren Kassette 33 hinüberführen und diese Kassette möglicherweise unter Verwendung einer Rutschbahn 32 mit fertiggestellten Halbleiterscheiben 6 beladen.

Auf die in Fig. 3 angedeutete Weise läßt sich das erfindungsgemäße Verfahren automatisieren.

Das erfindungsgemäße Verfahren kann zur Herstellung aller
Halbleiterbauelemente oder IC's verwendet werden, bei
denen eine einseitige Ätzung von Halbleiterscheiben nötig
ist.

6 Patentansprüche
3 Figuren

0044567

## Patentansprüche

1. Verfahren zur einseitigen Ätzung von Halbleiterscheiben, d a d u r c h   g e k e n n z e i c h n e t, daß die zu ätzende Halbleiterscheibe (6) mittels eines Drehgaskissens (7) so in einen Schwebezustand versetzt wird, daß die nicht zu ätzende Fläche der Halbleiterscheibe dem Drehgaskissen (7) zugewandt ist, während die zu ätzende Fläche der Halbleiterscheibe (6) freiliegt und daß die freiliegende Fläche der Halbleiterscheibe (6) mit Ätzmittel besprüht und wegen der Scheibenrotation gleichzeitig geschleudert wird, daß anschließend die freiliegende Fläche der Halbleiterscheibe mit Sprühmitteln besprüht und anschließend trockengeschleudert wird.

2. Verfahren nach Anspruch 1, d a d u r c h   g e k e n n - z e i c h n e t, daß das Ätzmittel vor dem Besprühen aufgeheizt wird.

3. Verfahren nach den Ansprüchen 1 oder 2, d a d u r c h   g e k e n n z e i c h n e t,   daß als Halbleitermaterial Silicium, als Ätzmittel Flußsäure und als Spülmittel deionisiertes Wasser verwendet wird.

4. Vorrichtung zur Durchführung des Verfahrens nach einem der Ansprüche 1 bis 3, d a d u r c h   g e k e n n - z e i c h n e t,   daß das Drehgaskissen (7) mittels eines Drehtellers (1) erzeugt wird, der eine axiale Gaszuführung enthält, die von einem geeigneten Gas durchströmt wird, daß der Drehteller (1) an seinem äußeren Umfang mehrere Anschlagbügel zur Halterung der Halbleiterscheibe aufweist, die so ausgeführt sind, daß sich bei Betrieb der Anordnung ein Drehgaskissen (7) zwischen dem Drehteller (1) und der Halbleiterscheibe (6) bildet, so daß die Halbleiterscheibe (6) an keiner Stelle den Drehteller (1) berührt,
daß eine oder mehrere Sprühvorrichtungen zum Besprühen

**0044567**

der dem Drehgaskissen (7) abgewandten Halbleiteroberfläche vorgesehen sind und

daß eine Auffangvorrichtung (12) für die verbrauchte Sprühflüssigkeit vorgesehen ist.

5. Vorrichtung nach Anspruch 4, d a d u r c h   g e -
k e n n z e i c h n e t,    daß an die Auffangvorrichtung
(12) eine Vorrichtung zum Erwärmen und Rückpumpen der
Flüssigkeit in die Sprühvorrichtung angeschlossen ist.

6. Vorrichtung nach den Ansprüchen 4 oder 5, d a d u r c h
g e k e n n z e i c h n e t,    daß zum Be- und Entladen
des Drehtellers die Halbleiterscheiben mittels schwenkbarer Saugpinzetten befördert werden.

FIG 1

FIG 2

FIG 3

**Europäisches Patentamt**

## EUROPÄISCHER RECHERCHENBERICHT

EP 81 10 5805.6

| Kategorie | EINSCHLÄGIGE DOKUMENTE Kennzeichnung des Dokuments mit Angabe, soweit erforderlich, der maßgeblichen Teile | betrifft Anspruch | KLASSIFIKATION DER ANMELDUNG (Int. Cl.³) |
|---|---|---|---|
| | DE - B - 1 248 169 (SIEMENS) <br> * Anspruch 1; Spalte 3, Zeilen 7 bis 38; Fig. 1, 2 * <br> --- | 1 | H 01 L 21/306 <br> H 01 L 21/68 |
| | IBM TECHNICAL DISCLOSURE BULLETIN, Band 17, Nr. 3, August 1974 New York KROGMANN et al. "Etch Holder for Semiconductor Wafers" Seiten 922 bis 923 <br> -- | 1,4 | |
| | DE - A1 - 2 736 000 (BURROUGHS) <br> * Ansprüche 1, 3; Seite 7, Zeile 1 bis Seite 9, Zeile 2; Fig. 1 * <br> -- | 1,4,5 | RECHERCHIERTE SACHGEBIETE (Int. Cl.³) <br><br> B 05 C 9/00 <br> B 05 C 11/00 <br> B 05 D 1/02 <br> B 65 G 51/00 <br> C 23 F 1/08 |
| P | US - A - 4 219 110 (UBUKATA) <br> * Spalte 4, Zeilen 32 bis 57; Spalte 7, Zeilen 47 bis 64 * <br> ----- | 4 | H 01 L 21/306 <br> H 01 L 21/68 |

**KATEGORIE DER GENANNTEN DOKUMENTE**

X: von besonderer Bedeutung
A: technologischer Hintergrund
O: nichtschriftliche Offenbarung
P: Zwischenliteratur
T: der Erfindung zugrunde liegende Theorien oder Grundsätze
E: kollidierende Anmeldung
D: in der Anmeldung angeführtes Dokument
L: aus andern Gründen angeführtes Dokument
&: Mitglied der gleichen Patentfamilie, übereinstimmendes Dokument

X Der vorliegende Recherchenbericht wurde für alle Patentansprüche erstellt.

| Recherchenort | Abschlußdatum der Recherche | Prüfer |
|---|---|---|
| Berlin | 21-10-1981 | GIBBS |

EPA form 1503.1 06.78